# EUROPEAN PATENT SPECIFICATION

(11) **EP 1 354 361 B1**
(45) Date of publication and mention of the grant of the patent: **18.07.2012**
(21) Application number: 02732134.8
(22) Date of filing: 14.01.2002
(51) Int. Cl.: H01L 27/148, H01L 29/768

(54) **SOLID STATE IMAGER ARRANGEMENTS**
FESTKORPERABBILDUNGSVORRICHTUNGEN
ENSEMBLES IMAGEURS A SEMI-CONDUCTEURS

(30) Priority: 18.01.2001 GB 0101301
(43) Date of publication of application: 22.10.2003
(73) Proprietor: E2V Technologies (UK) Limited, Chelmsford, Essex CM1 2QU (GB)
(72) Inventor: POOL, Peter, J., Essex CM9 6BJ (GB)
(74) Representative: Loveless, Ian Mark
(86) International application number: PCT/GB2002/000138
(87) International publication number: WO 2002/058157

(56) References cited:
- EP-A- 0 866 501
- WO-A-92/21151
- GB-A- 2 289 981

## Description

This invention relates to solid state imager arrangements and more particularly to arrangements in which signal charge multiplication is implemented.

In a typical charge coupled device (CCD) imager, signal charge representative of incident radiation is accumulated in an array of pixels over an image area. Following an integration period, signal charge is transferred to an output register by applying appropriate clocking or drive pulses to control electrodes. The signal charge is then read out from the output register and applied to a charge detection circuit to produce a voltage which is representative of the amount of signal charge.

Our previously published patent application, GB-A-2323471 discloses a CCD imager arrangement in which signal charge multiplication is obtained by providing a separate multiplication register following the output register. Charge is transferred through high field regions in elements of the multiplication register, thus accelerating the signal charge carriers and generating additional carriers through impact ionisation. As carrier multiplication occurs outside the conventional CCD structure itself, both the operation of the multiplication register and the CCD imager may be optimised without compromising the performance of one for the sake of the other.

WO 92/21151 and GB 2289981 disclose ways of discarding charge from a CCD device if not required.

The present invention seeks to provide an improved solid state imager arrangement.

According to the present invention, there is provided a solid state imager arrangement comprising: an image area, an output register which receives signal charge from the image area, a separate multiplication register into which signal charge from the output register is transferred, means for obtaining signal charge multiplication by transferring the charge through a sufficiently high field in elements of the multiplication register, and an additional register into which excess signal charge is transferred.

The invention is particularly suitable for arrangements in which the solid state imager is a CCD imager but it may be applicable to other types of solid state device in which packets of signal charge are transferred into an output register.

The excess signal charge is that charge originating from the image area which does not pass entirely through the charge multiplication register. In the previously proposed arrangement, in parts of a scene of high illumination there is a risk that the well capacities in the multiplication register can be exceeded, leading to saturation and loss of image resolution. Thus, a drain region may be included which accepts charge exceeding a threshold value to avoid saturation.

The present inventor has realised that although the previously proposed structure offers good performance, it is possible to enhance it still further. The inclusion of an additional register to accept excess charge means that in circumstances where the well capacities of the multiplication register are likely to be exceeded, some of the signal charge originating from the image area is diverted away from the multiplication part of the arrangement. Instead, this excess signal charge is transferred to the additional register, which is a structure also capable of holding charge packets which may be controllably moved through the additional register. The remaining charge which passes through each multiplication stage may then be recombined with the excess charge from the additional register. For example, the signal charge packet may be reconstituted by appropriate synchronised clocking of the two register outputs to give an output which comprises the excess charge plus the amplified remaining charge which passed through all stages of the multiplication register. The combining step is conveniently carried out before any further processing of the signal charge is carried out but it could be implemented at a later stage in the processing sequence, for example after charge has been converted at the charge detection circuit or following conversion into video output. It may not always be necessary to synchronise the multiplication and additional register readouts providing provision is made for combining charge packets originating from the same output register elements.

By using the invention, the dynamic range may be increased in comparison with the previous arrangement. In the previous arrangement, charge is lost to preserve image resolution at high illumination levels. With the present invention, the additional register acts as an overflow to store the excess signal charge which can then be usefully added back to the multiplied charge instead of being discarded. This gives the capability for the same imager arrangement to be used for both low light conditions and daylight conditions. It also permits dark and bright images in a scene to be detected simultaneously without loss of resolution in the high intensity regions.

The dynamic range capability of a CCD is often described by the ratio of the saturation signal to the read noise. In the previous device employing a multiplication register, the transfer curve is linear and saturation is determined by the charge handling capability of the output circuit or of the elements of the multiplication register. Since gain implemented by the multiplication register may be 200 times or greater, the saturation signal may represent less than 1% of the well capacity of the pixel. By employing the invention, however, the whole range of pixel well capacity may be used, giving the consequent increase in dynamic range.

The transfer of excess signal charge into the additional register may be accomplished by passive means or by active means, such as a gate electrode structure to which control signals are applied.

There are several ways in which excess charge may be separated from the remaining charge which is transferred through each element of the multiplication register. In one embodiment, the signal charge from the output register is applied to the multiplication register. The charge is increased as it is clocked through the multiplication register and undergoes signal multiplication. The additional register is located adjacent the multiplication register, separated therefrom by a potential barrier. Excess charge from the multiplication register flows over the barrier and into a corresponding element of the additional register. The signal charge from the two registers may be detected on separate amplifiers or combined and detected on a single output as the sum of the two register outputs

If the multiplication register has a peak capacity N electrons and a gain of G, the response is linear up to N/G electrons and then logarithmic to N electrons. Thus, the dynamic range is effectively extended by a factor of approximately G.

The excess signal charge may be transferred to the additional register via one or more elements of the multiplication register as described above. In another embodiment, excess charge is separated from the remainder of the signal charge before the remainder is applied to the multiplication register. For example, signal charge may be detected or sampled either before application of the charge packet to the multiplication register or via one or more elements of the multiplication register. Subsequent transfer of the excess signal charge to the additional register may then be carried out depending on the magnitude of signal charge detected. For example, if it is determined that the signal charge in the first element of multiplication register would lead to saturation in the final element of the multiplication register, following amplification as the charge is transferred through the multiplication register, an amount of signal charge suitable to prevent saturation from occurring may be diverted as excess charge to the additional register. In another embodiment, a fixed percentage of the signal charge may always be diverted to the additional register as excess charge, but this may lead to some reduction in the amount of multiplication which could otherwise be achieved.

The excess signal charge may simply be that which exceeds a threshold level at some stage in the transfer of the signal charge through the multiplication register. The threshold level may be fixed or may be variable to take into account changes in the scene being viewed by the arrangement and/or ambient conditions.

The arrangement may be such that each element of the multiplication register corresponds to and is in communication with an element in the additional register, with transfer of excess charge being possible from each element in the multiplication register. In another arrangement, such transfer may only be possible from certain of the elements of the multiplication register, for example from alternate elements or from elements towards the output end of the multiplication register.

In a preferred embodiment, the additional register is located physically close to the multiplication register so as to permit direct transfer of charge between the two via the intervening structure. However, they could be remotely located with respect to one another with charge being transferred via intervening circuitry and clocking techniques.

The invention is most applicable to an arrangement in which a single multiplication and a single additional register are included. However, in some embodiments, a multiplication register may be associated with a plurality of additional registers, which may be arranged in parallel or in a cascade arrangement. Also, a plurality of multiplication registers, each with its own additional register or registers, may be included in an arrangement to accept signal charge from a single output register. These architectures however are somewhat complicated and it is not apparent that the complexity would be off-set by improved performance.

Some ways in which the invention may be performed are now described by way of example with reference to the accompanying drawings, in which:
Figure 1 schematically shows a CCD imager arrangement in accordance with the invention; and
Figures 2 to 4 show other arrangements in accordance with the invention.

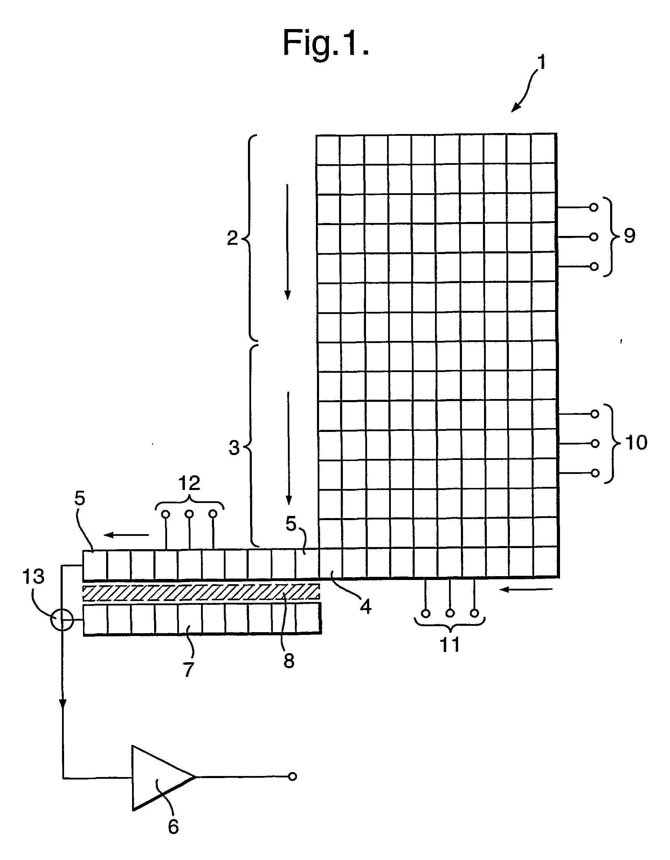

With reference to Figure 1, a CCD imager 1 includes an image area 2, a store section 3 and an output or readout register 4. The output register 4 is extended linearly to provide a multiplication register 5, the output of which is connected to a charge detection circuit 6. An additional register 7 having the same number of elements as the multiplication register 5 is located physically adjacent to the multiplication register 5, an implanted barrier region 8, shown schematically, being located between the two registers 5 and 7.

During operation of the device, incident radiation is converted at the image area 2 into signal charge representative of the intensity of radiation which impinges on the pixel array making up the image area 2. Following an integration period during which image acquisition occurs, drive pulses are applied to control electrodes 9 to transfer charge accumulated at the pixels of the image area 2 to the store section 3. Simultaneously, drive signals are also applied to control electrodes 10 at the store section 3 to cause charge to be transferred row by row towards the output register 4.

When a row of signal charge has been transferred to the output register 4, appropriate drive pulses are applied to electrodes 11 to sequentially transfer the signal charge from the elements of the output register 4 to those of the multiplication register 5, which is of similar architecture to the output register.

Multiplication of charge is implemented at each element of the multiplication register 5. High amplitude drive pulses, at the rate at which charge is clocked through the output register 4, are applied to control electrodes 12 to both transfer signal charge from one element to the next adjacent element in the direction show by the arrow and also to increase the level of signal charge by an amount determined by the amplitude of the drive pulses. As each packet of charge is transferred through the multiplication register from one element to the next, the signal charge increases. The output of the multiplication register 5 is applied to the charge detector 6, this being a multiplied version of the signal charge collected in the output register 4. At each stage of the multiplication register 5, the signal charge is increased and each signal charge packet stored in the output register 4 undergoes identical multiplication process as each travels through all the elements of the multiplication register 5. In another embodiment, signal charge multiplication is dependent on the level of one or more dc potentials applied to the register.

The above description of the operation of the arrangement shown in Figure 1 is carried out when the signal charge collected at the image area 2 is relatively small and thus saturation does not occur during transfer through the multiplication register 5, the well capacity of the final element or elements of the register 5 being sufficient to accommodate the multiplied charge packets. However, in the event that the charge collected increases beyond the well capacity of the elements of the register 5, some of the charge is transferred from the elements of the multiplication register 5 via the implanted barrier into corresponding elements of the additional register 7. The amount of excess charge transferred to the additional register 7 is dependent on the barrier potential. In this embodiment, the barrier potential is fixed and is uniform along the length of the multiplication and additional registers 5 and 7. In other devices the potential is variable via control electrodes and/or is non-uniform. If the charge applied to the first element of the multiplication register 5 is reasonably small, so that at the final element 5 the well capacity would only be exceeded by a relatively small amount, transfer via the barrier between the two registers only occurs between elements at the ends of the registers where the charge has undergone the most multiplication, for example, over the last two or three elements. Where a larger signal charge appears at the first element of the multiplication register 5, then transfer of the excess charge to the additional register 7 occurs over a greater length of the two registers, transfer being possible between each element of the multiplication register 5 and a corresponding element of the additional register 7. The two registers 5 and 7 are clocked in synchronism so that the charge appearing at the final element of the two registers originated with the same packet of signal charge from a common pixel of the image area 2. The outputs of the two registers are then combined at combiner 13 prior to being applied to the charge detector 6. In one embodiment, the registers are clocked in synchronism with line timing of a television signal.

The elements of the multiplication and/or additional registers may have the same charge capacity, or elements nearer the end or ends may have larger charge capacity.

In another embodiment, a control gate structure is disposed between the multiplication register 5 and additional register 7 to control the transfer of excess charge to the latter by applying suitable control pulses. A combination of the two approaches may be used.

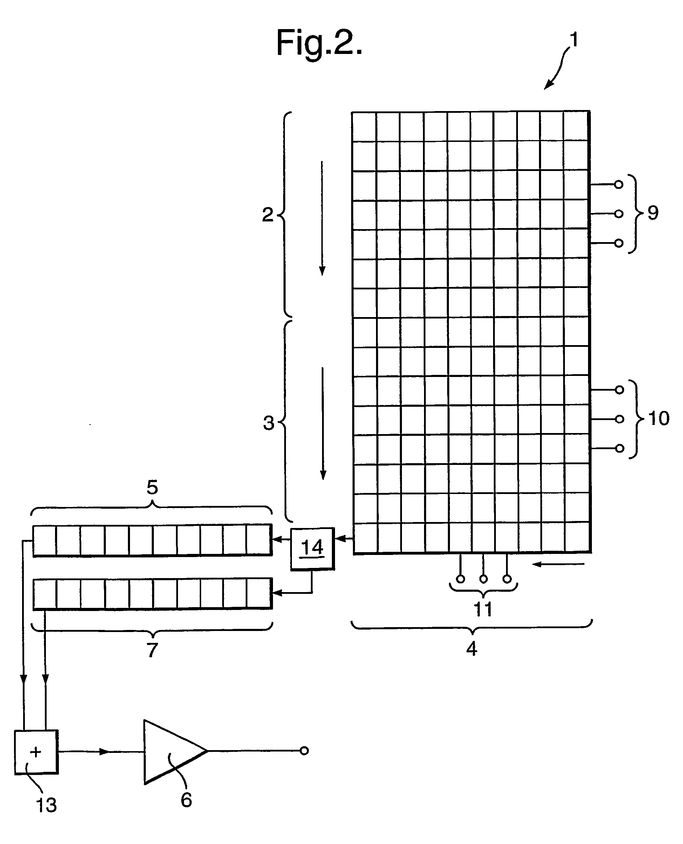

Figure 2 illustrates another embodiment of the invention in which a processing circuit is located between the output register 4 and the multiplication register 5. A detector circuit 14 detects the amount of charge for an element from the output register 4 and causes a fixed percentage of that charge to be diverted to the additional register 7. In other respects, the arrangement is similar to that shown in Figure 1. However, in this type of device, it is not necessary to arrange for the additional register 7 to be in physical proximity to the multiplication register 5 as there is no direct connection between the two for transfer of excess charge to the additional register 7.

In the devices of Figures 1 and 2, the charge from the multiplication register and that from the additional register is recombined prior to being applied to charge detector 6. In other arrangements, recombination is carried out at a later stage in the processing of the output signal. Also, it may be desirable in some applications to add a multiplication capability to the additional register 7, which performs in a similar way to that of the multiplication register 5.

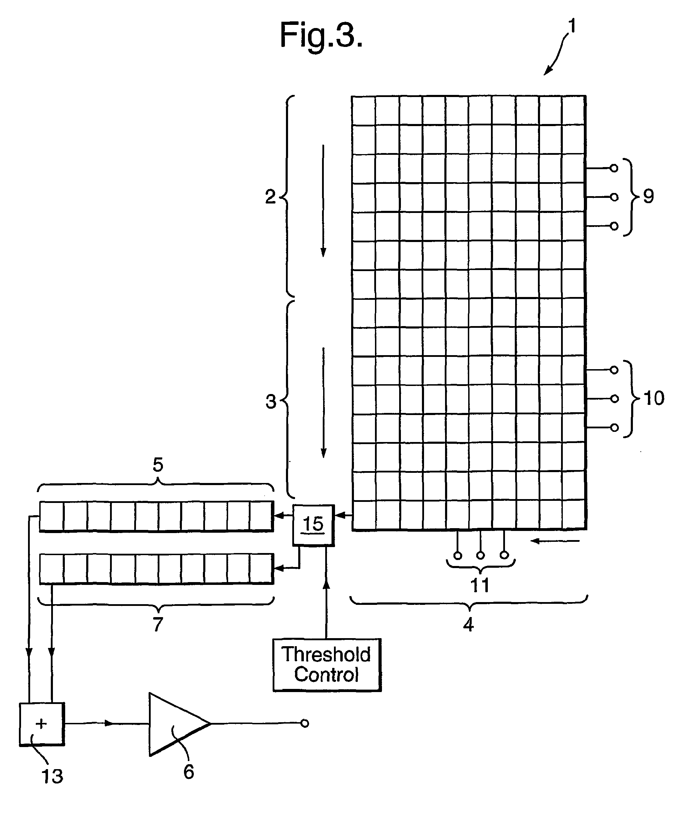

With reference to Figure 3, in another embodiment similar to that shown in Figure 2, a threshold circuit 15 replaces the detector circuit 14 and acts on applied signal charge to divert charge exceeding a threshold level to the additional register 7. The threshold level can be fixed or variable. For example, it may be arranged to automatically track changes in ambient temperature or other parameters, or it could be controllably adjustable.

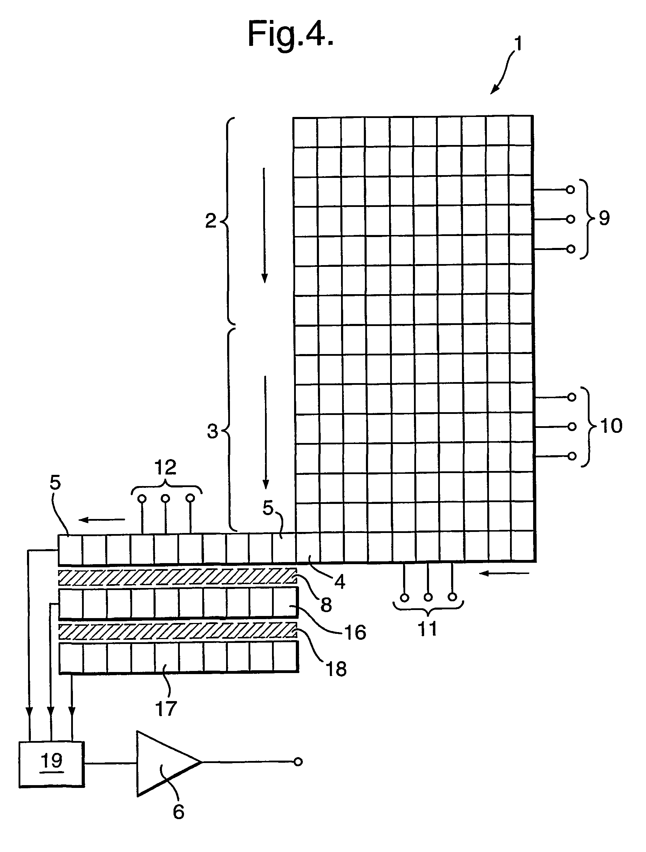

With reference to Figure 4, a device similar to that of Figure 1 also includes an implanted barrier 8 between a multiplication register 5 and additional register means for carrying excess charge. However the register means includes two additional registers 16 and 17 also having an implanted barrier 18 between them. Excess charge from additional register 16 is thus transferred to additional register 17, and outputs of the three registers are recombined at combiner 19. This arrangement may be advantageous where signal charge multiplication is carried out in the first additional register 16 as well as in the multiplication register 5. In other architectures (not shown), several additional registers may be arranged in communication with a respective different set of the elements of the multiplication register.

## Claims

1. A solid state imager arrangement comprising: an image area (2), an output register (4) arranged to receive signal charge from the image area, a multiplication register (5) arranged to receive signal charge from the output register, means for transferring the charge through a sufficiently high field in elements of the multiplication register to obtain signal charge multiplication by generating additional carriers through impact ionisation, and **characterised by** an additional register (7) into which excess signal charge is transferred, arranged to divert some of the signal charge away from the multiplication register.

2. An arrangement as claimed in claim 1 wherein the excess signal charge is that exceeding a threshold level.

3. An arrangement as claimed in claim 2 wherein the threshold level is variable.

4. An arrangement as claimed in claim 1 wherein the excess signal charge is a percentage of the signal charge received from the image area.

5. An arrangement as claimed in any preceding claim wherein excess signal charge is transferred to the additional register via one or more elements of the multiplication register.

6. An arrangement as claimed in claim 5 wherein excess signal charge is transferable from each element of the multiplication register to the additional register.

7. An arrangement as claimed in any of claims 1 to 4 wherein signal charge from the output register is applied to a separator which separates the excess signal charge from remaining signal charge, the excess charge being transferred to the additional register and the remaining signal charge to the multiplication register.

8. An arrangement as claimed in any preceding claim wherein the multiplication register and additional register have the same number of elements.

9. An arrangement as claimed in any preceding claim and wherein the amount of excess charge transferred to the additional register is determined by implanted barrier means.

10. An arrangement as claimed in claim 9 wherein the barrier means is located between the multiplication register and the additional register.

11. An arrangement as claimed in any preceding claim and including gate means for controlling the transfer of excess signal charge to the additional register.

12. An arrangement as claimed in any preceding claim and including means for combining signal charge after it has been transferred through the multiplication register with excess charge from the additional register.

13. An arrangement as claimed in any preceding claim wherein signal charge multiplication is obtained in the additional register.

14. An arrangement as claimed in any preceding claim and including a plurality of additional registers associated with the multiplication register.

15. An arrangement as claimed in any preceding claim wherein a sufficiently high field region is obtained in each element of the multiplication register.

16. An arrangement as claimed in any preceding claim and including means for synchronising signal readout from the multiplication register with line timing of a television rate signal.

17. An arrangement as claimed in any preceding claim wherein signal charge is clocked through the multiplication register and excess charge through the additional register at the same rate as charge is clocked through the output register.

18. An arrangement as claimed in any preceding claim wherein the amount of signal charge multiplication is controlled by controlling the amplitude of one or more drive pulses applied to a register to transfer signal charge therethrough.

19. An arrangement as claimed in any preceding claim wherein the amount of signal charge multiplication is controlled by controlling the level of one or more dc potentials applied to a register.

20. An arrangement as claimed in any preceding claim wherein the charge capacity of at least some of the elements of the multiplication register is larger than that of elements of the output register.

21. An arrangement as claimed in any preceding claim and including a plurality of multiplication registers arranged to receive signal charge from the output register, at least one of the plurality having associated therewith an additional register.

22. An arrangement as claimed in any preceding claim wherein the solid imager is a CCD imager.

## Patentansprüche

1. Festkörperimager-Anordnung, die Folgendes umfasst: einen Bildbereich (2), ein Ausgangsregister (4) zum Empfangen einer Signalladung von dem Bildbereich, ein Multiplikationsregister (5) zum Empfangen einer Signalladung vom Ausgangsregister, Mittel zum Übertragen der Ladung durch ein ausreichend hohes Feld in Elementen des Multiplikationsregisters, um Signalladungsmultiplikation durch Erzeugen zusätzlicher Träger durch Stoßionisation zu erhalten, und **gekennzeichnet durch** ein Zusatzregister (7), in das überschüssige Signalladung übertragen wird, um einen Teil der Signalladung vom Multiplikationsregister weg zu leiten.

2. Anordnung nach Anspruch 1, wobei die überschüssige Signalladung die ist, die einen Schwellenwert übersteigt.

3. Anordnung nach Anspruch 2, wobei der Schwellenwert variabel ist.

4. Anordnung nach Anspruch 1, wobei die überschüssige Signalladung ein Prozentanteil der von dem Bildbereich erhaltenen Signalladung ist.

5. Anordnung nach einem der vorherigen Ansprüche, wobei überschüssige Signalladung über ein oder mehrere Elemente des Multiplikationsregisters zum Zusatzregister übertragen wird.

6. Anordnung nach Anspruch 5, wobei überschüssige Signalladung von jedem Element des Multiplikationsregisters zum Zusatzregister übertragen werden kann.

7. Anordnung nach einem der Ansprüche 1 bis 4, wobei Signalladung vom Ausgangsregister an einen Separator angelegt wird, der die überschüssige Signalladung von der restlichen Signalladung trennt, wobei die überschüssige Signalladung zum Zusatzregister und die restliche Signalladung zum Multiplikationsregister übertragen wird.

8. Anordnung nach einem der vorherigen Ansprüche, wobei das Multiplikationsregister und das Zusatzregister dieselbe Anzahl von Elementen haben.

9. Anordnung nach einem der vorherigen Ansprüche, wobei die Menge an zum Zusatzregister übertragener überschüssiger Ladung durch eine implantierte Barriere bestimmt wird.

10. Anordnung nach Anspruch 9, wobei sich die Barriere zwischen dem Multiplikationsregister und dem Zusatzregister befindet.

11. Anordnung nach einem der vorherigen Ansprüche, die ein Gatter zum Regulieren der Übertragung von überschüssiger Signalladung zum Zusatzregister beinhaltet.

12. Anordnung nach einem der vorherigen Ansprüche mit Mitteln zum Kombinieren von Signalladung, nachdem diese durch das Multiplikationsregister übertragen wurde, mit überschüssiger Ladung vom Zusatzregister.

13. Anordnung nach einem der vorherigen Ansprüche, wobei Signalladungsmultiplikation im Zusatzregister erzielt wird.

14. Anordnung nach einem der vorherigen Ansprüche mit mehreren mit dem Multiplikationsregister assoziierten Zusatzregistern.

15. Anordnung nach einem der vorherigen Ansprüche, wobei eine ausreichend hohe Feldregion in jedem Element des Multiplikationsregisters erhalten wird.

16. Anordnung nach einem der vorherigen Ansprüche mit Mitteln zum Synchronisieren von Signalauslesung aus dem Multiplikationsregister mit Zeilentiming eines Signals mit Fernsehsignalrate.

17. Anordnung nach einem der vorherigen Ansprüche, wobei Signalladung durch das Multiplikationsregister und überschüssige Ladung durch das Zusatzregister mit derselben Rate wie Ladung durch das Ausgangsregister getaktet wird.

18. Anordnung nach einem der vorherigen Ansprüche, wobei die Menge an Signalladungsmultiplikation durch Regeln der Amplitude von einem oder mehreren Ansteuerungsimpulsen geregelt wird, die an ein Register angelegt werden, um Signalladung durch es zu übertragen.

19. Anordnung nach einem der vorherigen Ansprüche, wobei die Menge an Signalladungsmultiplikation durch Regeln des Pegels von einem oder mehreren der an ein Register gelegten Potentiale geregelt wird.

20. Anordnung nach einem der vorherigen Ansprüche, wobei die Ladungskapazität von wenigstens einigen der Elemente des Multiplikationsregisters höher ist als die von Elementen des Ausgangsregisters.

21. Anordnung nach einem der vorherigen Ansprüche mit mehreren Multiplikationsregistern zum Empfangen von Signalladung vom Ausgangsregister, wobei mit wenigstens einem aus der Mehrzahl ein Zusatzregister assoziiert ist.

22. Anordnung nach einem der vorherigen Ansprüche, wobei der Festkörper-Imager ein CCD-Imager ist.

## Revendications

1. Agencement d'imageur à semi-conducteurs comprenant : une zone d'image (2), un registre de sortie (4) agencé pour recevoir une charge de signal de la zone d'image, un registre de multiplication (5) agencé pour recevoir une charge de signal du registre de sortie, un moyen pour transférer la charge à travers un champ suffisamment fort dans des éléments du registre de multiplication pour obtenir la multiplication de la charge de signal en générant des porteuses supplémentaires par ionisation par choc, et **caractérisé par** un registre supplémentaire (7) dans lequel une charge de signal excessive est transférée, agencé pour détourner une partie de la charge de signal à l'écart du registre de multiplication.

2. Agencement selon la revendication 1, dans lequel la charge de signal excessive est celle qui dépasse un niveau seuil.

3. Agencement selon la revendication 2, dans lequel le niveau seuil est variable.

4. Agencement selon la revendication 1, dans lequel la charge de signal excessive est un pourcentage de la charge de signal reçue de la zone d'image.

5. Agencement selon l'une quelconque des revendications précédentes, dans lequel la charge de signal excessive est transférée à un registre supplémentaire via un ou plusieurs éléments du registre de multiplication.

6. Agencement selon la revendication 5, dans lequel la charge de signal excessive peut être transférée au registre supplémentaire depuis chaque élément du registre de multiplication.

7. Agencement selon l'une quelconque des revendications 1 à 4, dans lequel la charge de signal du registre de sortie est appliquée à un séparateur qui sépare la charge de signal excessive de la charge de signal restante, la charge excessive étant transférée au registre supplémentaire et la charge de signal restante au registre de multiplication.

8. Agencement selon l'une quelconque des revendications précédentes, dans lequel le registre de multiplication et le registre supplémentaire ont le même nombre d'éléments.

9. Agencement selon l'une quelconque des revendications précédentes et dans lequel la quantité de charge excessive transférée au registre supplémentaire est déterminée par un moyen de barrière implanté.

10. Agencement selon la revendication 9, dans lequel le moyen de barrière est situé entre le registre de multiplication et le registre supplémentaire.

11. Agencement selon l'une quelconque des revendications précédentes et incluant un moyen de porte pour contrôler le transfert de la charge de signal excessive au registre supplémentaire.

12. Agencement selon l'une quelconque des revendications précédentes et incluant un moyen pour combiner la charge de signal après qu'elle eut été transférée par le registre de multiplication avec une charge excessive du registre supplémentaire.

13. Agencement selon l'une quelconque des revendications précédentes, dans lequel la multiplication de la charge de signal est obtenue dans le registre supplémentaire.

14. Agencement selon l'une quelconque des revendications précédentes et incluant une pluralité de registres supplémentaires associés au registre de multiplication.

15. Agencement selon l'une quelconque des revendications précédentes, dans lequel une région de champ suffisamment fort est obtenue dans chaque élément du registre de multiplication.

16. Agencement selon l'une quelconque des revendications précédentes et incluant un moyen pour synchroniser une lecture de signal du registre de multiplication sur un rythme de lignes d'un signal de cadence de télévision.

17. Agencement selon l'une quelconque des revendications précédentes, dans lequel la charge de signal est synchronisée par le registre de multiplication et la charge excessive par le registre supplémentaire à la même vitesse que la charge est synchronisée par le registre de sortie.

18. Agencement selon l'une quelconque des revendications précédentes, dans lequel le degré de multiplication de la charge de signal est contrôlé en contrôlant l'amplitude d'une ou de plusieurs impulsions d'entraînement appliquées à un registre pour transférer la charge de signal par celui-ci.

19. Agencement selon l'une quelconque des revendications précédentes, dans lequel le degré de multiplication de la charge de signal est contrôlé en contrôlant le niveau d'un ou de plusieurs potentiels cc appliqués à un registre.

20. Agencement selon l'une quelconque des revendications précédentes, dans lequel la capacité de charge d'au moins certains des éléments du registre de multiplication, est plus grande que celle des éléments du registre de sortie.

21. Agencement selon l'une quelconque des revendications précédentes et incluant une pluralité de registres de multiplication agencés pour recevoir une charge de signal du registre de sortie, au moins une pluralité ayant un registre supplémentaire associé à celle-ci.

22. Agencement selon l'une quelconque des revendications précédentes, dans lequel l'imageur à semi-conducteurs est un imageur CCD.
